# EUROPÄISCHE PATENTSCHRIFT

(11) **EP 3 505 943 B1**
(45) Veröffentlichungstag und Bekanntmachung des Hinweises auf die Patenterteilung: **20.05.2020**
(21) Anmeldenummer: 17211117.1
(22) Anmeldetag: 29.12.2017
(51) Int. Cl.: G01R 27/00, G01R 31/12

(54) **NACHWEISEN EINER ELEKTRISCHEN ÜBERSPANNUNG**
DETECTION OF AN ELECTRICAL OVERVOLTAGE
DÉTECTION D'UNE SURTENSION ÉLECTRIQUE

(43) Veröffentlichungstag der Anmeldung: 03.07.2019
(73) Patentinhaber: Siemens Aktiengesellschaft, 80333 München (DE)
(72) Erfinder: Heller, Janis, 97616 Bad Neustadt (DE); Katzenberger, Tobias, 97631 Bad Königshofen STT Untereßfeld (DE); Plochmann, Bastian, 91413 Neustadt an der Aisch (DE)

(56) Entgegenhaltungen:
- DE-A1- 4 004 445
- US-A1- 2015 066 399
- US-B1- 7 990 156

## Beschreibung

Die Erfindung betrifft eine Nachweisvorrichtung und ein Verfahren zum Nachweisen einer elektrischen Überspannung zwischen zwei elektrischen Leitern.

Die US 2015/066399 A1 (KASAI JUN, 5. März 2015) beschreibt ein Verfahren zum Nachweisen einer elektrischen Überspannung durch Messen des Widerstandes zwischen einer ersten und einer zweiten Leiterbahn. Es wird auf eine (durch Überspannung / Teilentladung) verminderte elektrische Isolation geschlossen, wenn der Widerstandswert zwischen den beiden Leiterbahnen einen zu niedrigen Widerstandswert annimmt. Überspannungen zwischen isolierten elektrischen Leitern können insbesondere die Isolierung der Leiter beeinträchtigen. Eine Isolierung weist typischerweise fertigungsbedingt Fehlstellen in Form von Poren und Spalten mit Ausdehnungen im Mikrometer- bis Millimeterbereich auf. Überspannungen können in einer Isolierung Teilentladungen verursachen, die aufgrund der meist niedrigeren Dielektrizitätskonstante vor allem in derartigen Fehlstellen gemäß dem Paschen-Gesetz ab einer gewissen Feldstärke des elektrischen Feldes durch einen Lawineneffekt von Ladungsträgern zünden. Durch derartige Teilentladungen wird die Isolierung vor allem im Bereich von Fehlstellen sukzessive verschlechtert bis es zum Ausfall der Isolierung kommt.

Beispielsweise treten derartige Schädigungen von Isolierungen elektrischer Leiter in rotierenden elektrischen Maschinen auf, die mit Umrichtern oder in umrichtergespeisten Umfeldern betrieben werden. Ein Umrichter erzeugt in der Regel eine rechteck- oder treppenförmige Umrichterspannung. Infolge der steilen Flanken einer derartigen Umrichterspannung weist das Fourierspektrum der Umrichterspannung Spektralanteile auf, die an einer Erregerwicklung einer von dem Umrichter gespeisten elektrischen Maschine Überspannungen bewirken, für die die Isolierung der Erregerwicklung nicht ausgelegt ist und die die Isolierung auf die oben beschriebene Weise schädigen können.

Die Qualität und der Zustand der Isolierung einer Erregerwicklung einer rotierenden elektrischen Maschine sind von außen in der Regel nicht quantitativ feststellbar, so dass ein Totalausfall der elektrischen Maschine durch einen von einer Isolierungsschädigung verursachten elektrischen Durchschlag, beispielsweise zwischen den Erregerwicklungen zweier verschiedener Phasen der Maschine oder zwischen einer Erregerwicklung und einem geerdeten Leiter, nicht prognostizierbar ist.

Der Erfindung liegt die Aufgabe zugrunde, eine Nachweisvorrichtung und ein Verfahren zum Nachweisen einer elektrischen Überspannung zwischen zwei elektrischen Leitern anzugeben, die insbesondere geeignet sind, Überspannungen in elektrischen Maschinen nachzuweisen.

Die Aufgabe wird erfindungsgemäß durch eine Nachweisvorrichtung mit den Merkmalen des Anspruchs 1, eine elektrische Maschine mit den Merkmalen des Anspruchs 14 und ein Verfahren mit den Merkmalen des Anspruchs 16 gelöst.

Vorteilhafte Ausgestaltungen der Erfindung sind Gegenstand der abhängigen Ansprüche.

Eine erfindungsgemäße Nachweisvorrichtung zum Nachweisen einer elektrischen Überspannung zwischen zwei elektrischen Leitern umfasst einen aus einem elektrisch isolierenden Trägermaterial gefertigten Leiterbahnträger, wenigstens zwei voneinander beabstandet auf dem Leiterbahnträger aufgebrachte Leiterbahnen und eine Messvorrichtung zum Erfassen eines elektrischen Widerstandes einer ersten Leiterbahn. Jeder elektrische Leiter ist mit wenigstens einer der Leiterbahnen elektrisch verbunden und keine Leiterbahn ist mit beiden elektrischen Leitern elektrisch verbunden. Die Leiterbahnen sind derart ausgebildet und angeordnet, dass eine vorgegebene Überspannung zwischen den elektrischen Leitern eine den elektrischen Widerstand der ersten Leiterbahn ändernde Teilentladung zwischen der ersten Leiterbahn und einer Leiterbahn, die mit einem der beiden elektrischen Leiter elektrisch verbunden ist, bewirkt.

Die erfindungsgemäße Nachweisvorrichtung ermöglicht, eine Überspannung nachzuweisen, indem durch die Überspannung der elektrische Widerstand einer Leiterbahn geändert wird, so dass die Überspannung durch die Messung dieses elektrischen Widerstandes nachgewiesen werden kann. Dabei nutzt die Erfindung aus, dass der elektrische Widerstand einer geeignet ausgebildeten Leiterbahn durch eine Teilentladung geändert werden kann. Dementsprechend wird erfindungsgemäß zum Nachweis einer Überspannung durch die Überspannung eine Teilentladung ausgelöst, die den elektrischen Widerstand einer Leiterbahn der Nachweisvorrichtung ändert. Insbesondere ermöglicht die Erfindung, Überspannungen an Spulenwicklungen einer elektrischen Maschine zu detektieren, ohne die Maschine abschalten oder öffnen zu müssen. Dadurch können im laufenden Betrieb der Maschine rechtzeitig Überspannungen erkannt werden, die zu Schädigungen der Isolierungen der Spulenwicklungen und schließlich zu einem Totalausfall der Maschine führen können.

Eine Ausgestaltung der Erfindung sieht vor, dass die erste Leiterbahn zwischen zwei Leiterbahnen, die jeweils mit einem der beiden elektrischen Leiter elektrisch verbunden sind, und von diesen Leiterbahnen beabstandet angeordnet und nicht mit einem der beiden elektrischen Leiter elektrisch verbunden ist. Bei dieser Ausgestaltung der Erfindung ist diejenige Leiterbahn, deren elektrischer Widerstand gemessen und zum Nachweis der Überspannung verwendet wird, mit keinem der elektrischen Leiter verbunden, zwischen denen eine Überspannung detektiert werden soll. Dies ist insbesondere vorteilhaft, wenn zwischen den elektrischen Leitern eine Hochspannung anliegt, da die Messvorrichtung bei dieser Ausgestaltung mit keinem der elektrischen Leiter elektrisch verbunden ist und somit nicht in Kontakt mit der Hochspannung kommt.

Eine zur vorgenannten Ausgestaltung alternative Ausgestaltung der Erfindung sieht vor, dass die erste Leiterbahn mit einem der beiden elektrischen Leiter elektrisch verbunden ist. Bei dieser Ausgestaltung der Erfindung ist diejenige Leiterbahn, deren elektrischer Widerstand gemessen und zum Nachweis der Überspannung verwendet wird, mit einem der elektrischen Leiter verbunden, zwischen denen eine Überspannung detektiert werden soll. Gegenüber der vorgenannten Ausgestaltung der Erfindung kann dadurch die Anzahl der Leiterbahnen der Nachweisvorrichtung reduziert werden und die Nachweisvorrichtung kann kompakter und preisgünstiger ausgeführt werden.

Eine weitere Ausgestaltung der Erfindung sieht vor, dass die Leiterbahnen aus einem Verbundwerkstoff gefertigt sind, der eine elektrisch nichtleitende Kunststoffmatrix und einen darin eingebetteten Füllstoff, durch den der Verbundwerkstoff elektrisch leitfähig ist, umfasst. Der Füllstoff weist beispielsweise elektrisch leitfähige Füllstoffpartikel auf, die Gitterplätze eines von der Kunststoffmatrix gebildeten Gitters mit einer Wahrscheinlichkeit besetzen, die größer als eine Perkolationsschwelle ist, oberhalb derer der Verbundwerkstoff elektrisch leitfähig ist, wobei die elektrische Leitfähigkeit von Füllstoffpartikeln durch eine auf die Füllstoffpartikel einwirkende Teilentladung reduziert wird. Der Füllstoff enthält beispielsweise n-leitendes Metalloxid, beschichteten oder unbeschichteten Glimmer, Quarzmehl, Ruß, Graphit oder/und Metall. Insbesondere kann der Füllstoff mit Antimon dotiertes Zinndioxid oder/und ein mit Fluor oder Indium dotiertes Zinnoxid enthalten. Die Kunststoffmatrix ist beispielsweise aus einem chemisch vernetzten Duroplast oder aus einem Thermoplast gefertigt. Diese Ausgestaltungen der Erfindung ermöglichen die Realisierung von Leiterbahnen, deren elektrischer Widerstand durch Teilentladungen erhöht wird, indem die Leiterbahnen aus einem geeigneten in eine Kunststoffmatrix eingebetteten Füllstoff gefertigt werden. Beispielsweise bilden Füllstoffpartikel aus mit Antimon dotiertem Zinndioxid bei ihrer Herstellung von selbst Sauerstofffehlstellen, die als Ladungsträger-Donatoren wirken und zur guten elektrischen Leitfähigkeit des Füllstoffes beitragen. Eine durch eine Überspannung verursachte Teilentladung erhitzt den Füllstoff lokal und bewirkt eine lokale Erzeugung von Ozon. Durch den Temperaturanstieg und das entstandene Ozon oxidieren Oberflächenrandschichten der Füllstoffpartikel mit Sauerstofffehlstellen. Dadurch wird die Anzahl der Sauerstofffehlstellen im Füllstoff reduziert und die elektrische Leitfähigkeit des Verbundwerkstoffs wird reduziert beziehungsweise der elektrische Widerstand des Verbundwerkstoffs wird erhöht. Entsprechendes gilt für andere Füllstoffe aus einem n-leitenden Metalloxid, das zur Verbesserung seiner elektrischen Leitfähigkeit geeignet dotiert ist, beispielsweise mit einem chemischen Element, dessen Ordnungszahl im Periodensystem der Elemente um Eins höher als die Ordnungszahl des Metalls des Metalloxids ist. Füllstoffpartikel aus Ruß, Graphit oder Metall bilden bei Teilentladungen keine Oberflächenrandschichten der oben beschriebenen Art, sondern oxidieren bei Teilentladungen und verlieren dadurch ihre elektrische Leitfähigkeit, so dass sich der elektrische Widerstand des Verbundwerkstoffes auch in diesem Fall erhöht.

Eine zu den vorgenannten Ausgestaltungen alternative Ausgestaltung der Erfindung sieht vor, dass die Leiterbahnen aus einem elektrisch leitfähigen Kunststoff, beispielsweise aus Polyanilin (PANI) oder aus Poly(3,4-ethylendioxythiophen)-Polystyrolsulfonat (PEDOT:PSS) gefertigt sind. Auch derartige Kunststoffe eignen sich als Materialien zur Herstellung der Leiterbahnen, da ihre elektrische Leitfähigkeit durch Teilentladungen reduziert oder zerstört wird.

Eine weitere Ausgestaltung der Erfindung sieht vor, dass die Leiterbahnen jeweils eine Dicke von etwa 100 µm und einen elektrischen Flächenwiderstand, der vor einer Teilentladung höchstens 100 kQ beträgt, aufweisen. Diese Ausgestaltung berücksichtigt, dass bei der Herstellung der Leiterbahnen, beispielsweise durch Bedrucken des Leiterbahnträgers, ein Lösemittel erforderlich ist, das nach dem Aufbringen der Leiterbahn abgedampft wird. Bei einer zu großen Dicke der Leiterbahnen führt das Abdampfen des Lösemittels zu Rissen oder Poren in den Leiterbahnen, die deren Qualität beeinträchtigen. Eine Dicke von etwa 100 µm ist ein typischer Wert, bei dem die Leiterbahnen eine ausreichende elektrische Leitfähigkeit aufweisen und nicht durch das Abdampfen des Lösemittels beeinträchtigt werden. Unter dem auch als Quadratwiderstand bezeichneten elektrischen Flächenwiderstand einer elektrisch leitfähigen Schicht wird deren spezifischer Widerstand für eine definierte Schichtdicke verstanden. Ein elektrischer Flächenwiderstand von höchstens 100 kΩ ist bei einer Leiterbahndicke von etwa 100 µm vorteilhaft, da andernfalls ein wesentlicher Teil der Überspannung bereits in den Leiterbahnen abgebaut wird.

Eine weitere Ausgestaltung der Erfindung sieht vor, dass der Leiterbahnträger als ein Plättchen oder als eine Folie ausgebildet ist. Diese Ausgestaltung der Erfindung ermöglicht eine einfache und flexible Verwendung und Montage der Nachweisvorrichtung.

Eine weitere Ausgestaltung der Erfindung sieht vor, dass wenigstens einer der beiden elektrischen Leiter mit mehreren Leiterbahnen elektrisch verbunden ist, wobei die Leiterbahnen derart ausgebildet und angeordnet sind, dass verschiedene vorgegebene Überspannungen zwischen den elektrischen Leitern Teilentladungen zwischen der ersten Leiterbahn und verschieden vielen Leiterbahnen, die jeweils mit einem der beiden elektrischen Leiter elektrisch verbunden sind, bewirken. Diese Ausgestaltung der Erfindung ermöglicht die Verwendung derselben Nachweisvorrichtung zum Nachweis verschiedener Überspannungen.

Eine erfindungsgemäße elektrische Maschine weist eine erfindungsgemäße Nachweisvorrichtung zum Nachweisen einer elektrischen Überspannung zwischen zwei elektrischen Leitern auf, wobei einer der elektrischen Leiter eine Spulenwicklung der elektrischen Maschine ist und der andere elektrische Leiter eine andere Spulenwicklung der elektrischen Maschine oder ein geerdeter Leiter ist. Die elektrische Maschine ist beispielsweise eine rotierende elektrische Maschine oder ein Transformator. Die Vorteile einer derartigen elektrischen Maschine ergeben sich aus den oben genannten Vorteilen einer erfindungsgemäßen Nachweisvorrichtung.

Bei dem erfindungsgemäßen Verfahren zum Nachweisen einer elektrischen Überspannung zwischen zwei elektrischen Leitern mit einer erfindungsgemäßen Nachweisvorrichtung wird jeder elektrische Leiter mit wenigstens einer Leiterbahn der Nachweisvorrichtung elektrisch verbunden. Ferner wird der elektrische Widerstand der ersten Leiterbahn der Nachweisvorrichtung gemessen und auf eine elektrische Überspannung zwischen den elektrischen Leitern geschlossen, wenn der elektrische Widerstand der ersten Leiterbahn einen zu der Überspannung korrespondierenden Widerstandswert annimmt. Das erfindungsgemäße Verfahren ermöglicht den Nachweis einer elektrischen Überspannung zwischen zwei elektrischen Leitern mittels einer erfindungsgemäßen Nachweisvorrichtung durch die Erfassung des elektrischen Widerstands einer Leiterbahn der Nachweisvorrichtung.

Insbesondere kann das Verfahren vorteilhaft zum Nachweisen einer elektrischen Überspannung an einer Spulenwicklung einer elektrischen Maschine, insbesondere einer rotierenden elektrischen Maschine oder eines Transformators, verwendet werden. Dabei ist einer der elektrischen Leiter eine Spulenwicklung der elektrischen Maschine und der andere elektrische Leiter ist eine andere Spulenwicklung der elektrischen Maschine oder ein geerdeter Leiter.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: ein erstes Ausführungsbeispiel einer Nachweisvorrichtung zum Nachweisen einer elektrischen Überspannung,
- FIG 2: schematisch zwei Füllstoffpartikel eines in eine Kunststoffmatrix eingebetteten Füllstoffes und Energiebänder des Füllstoffes,
- FIG 3: ein zweites Ausführungsbeispiel einer Nachweisvorrichtung zum Nachweisen einer elektrischen Überspannung,
- FIG 4: ein drittes Ausführungsbeispiel einer Nachweisvorrichtung zum Nachweisen einer elektrischen Überspannung.

Einander entsprechende Teile sind in den Figuren mit denselben Bezugszeichen versehen.

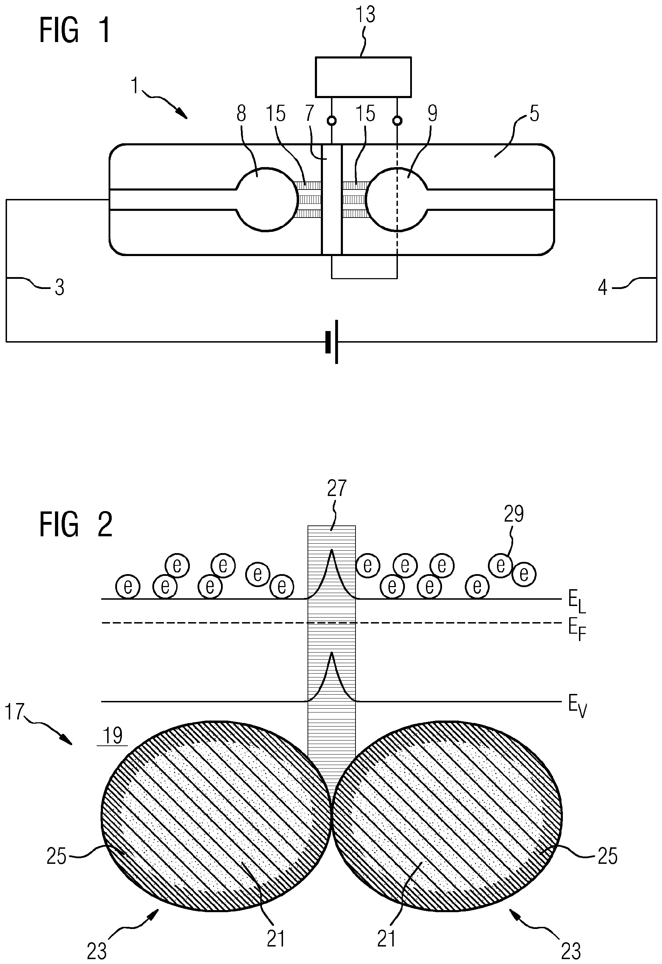

FIG 1 zeigt ein erstes Ausführungsbeispiel einer Nachweisvorrichtung 1 zum Nachweisen einer elektrischen Überspannung zwischen zwei elektrischen Leitern 3, 4. Die Nachweisvorrichtung 1 umfasst einen Leiterbahnträger 5, drei auf dem Leiterbahnträger 5 aufgebrachte Leiterbahnen 7, 8, 9 und eine Messvorrichtung 13 zum Erfassen eines elektrischen Widerstandes einer ersten Leiterbahn 7.

Der Leiterbahnträger 5 ist aus einem elektrisch isolierenden Trägermaterial, das als Substrat für die Leiterbahnen 7, 8, 9 dient, gefertigt und als ein Plättchen oder als eine Folie ausgebildet.

Die erste Leiterbahn 7 ist zwischen einer zweiten Leiterbahn 8 und der dritten Leiterbahn 9 und von der zweiten Leiterbahn 8 und der dritten Leiterbahn 9 beabstandet angeordnet. Die beiden Enden der ersten Leiterbahn 7 sind mit der Messvorrichtung 13 verbunden.

Die zweite Leiterbahn 8 und die dritte Leiterbahn 9 verlaufen jeweils senkrecht zu der ersten Leiterbahn 7. Ein der ersten Leiterbahn 7 zugewandtes Ende der zweiten Leiterbahn 8 und ein der ersten Leiterbahn 7 zugewandtes Ende der dritten Leiterbahn 9 sind jeweils kreisförmig ausgebildet.

Die zweite Leiterbahn 8 ist mit einem ersten elektrischen Leiter 3 elektrisch verbunden und liegt daher auf demselben elektrischen Potential wie der erste elektrische Leiter 3.

Die dritte Leiterbahn 9 ist mit dem zweiten elektrischen Leiter 4 elektrisch verbunden und liegt daher auf demselben elektrischen Potential wie der zweite elektrische Leiter 4.

Die Leiterbahnen 7, 8, 9 sind derart ausgebildet und angeordnet, dass eine vorgegebene Überspannung zwischen den elektrischen Leitern 3, 4 eine Teilentladung 15 zwischen der ersten Leiterbahn 7 und der zweiten Leiterbahn 8 oder/und zwischen der ersten Leiterbahn 7 und der dritten Leiterbahn 9 bewirkt, die den elektrischen Widerstand der ersten Leiterbahn 7 auf einen zu der Überspannung korrespondierenden Widerstandswert ändert. Um die Überspannung nachzuweisen, wird der elektrische Widerstand der ersten Leiterbahn 7 gemessen und es wird auf die Überspannung geschlossen, wenn der elektrische Widerstand der ersten Leiterbahn 7 den Widerstandswert annimmt.

Beispielsweise sind die Leiterbahnen 7, 8, 9 aus einem Verbundwerkstoff 17 gefertigt, der eine elektrisch nichtleitende Kunststoffmatrix 19 und einen darin eingebetteten Füllstoff 21, durch den der Verbundwerkstoff 17 elektrisch leitfähig ist, umfasst.

FIG 2 zeigt schematisch die Struktur eines Ausführungsbeispiels eines derart ausgebildeten Verbundwerkstoffs 17. Die Kunststoffmatrix 19 ist aus einem chemisch vernetzten Duroplast oder aus einem Thermoplast gefertigt. Beispielsweise ist die Kunststoffmatrix 19 aus einem Epoxid, Silikon, Polyurethan oder Polyetherimid gefertigt.

Der Füllstoff 21 weist elektrisch leitfähige Füllstoffpartikel 23 auf, die Gitterplätze eines von der Kunststoffmatrix 19 gebildeten Gitters mit einer Wahrscheinlichkeit besetzen, die größer als eine Perkolationsschwelle ist, oberhalb derer der Verbundwerkstoff 17 elektrisch leitfähig ist. Die Füllstoffpartikel 23 bilden also ein zusammenhängendes Partikelnetz in der Kunststoffmatrix 19, durch das der Verbundwerkstoff 17 elektrisch leitfähig ist.

Der Füllstoff 21 ist beispielsweise ein n-leitendes Metalloxid, das mit einem chemischen Element dotiert ist, dessen Ordnungszahl im Periodensystem der Elemente um Eins höher als die Ordnungszahl des Metalls des Metalloxids ist. Beispielsweise ist der Füllstoff 21 mit Antimon dotiertes Zinndioxid, ein mit Mangan dotiertes Chromoxid, ein mit Cobalt dotiertes Eisenoxid oder ein mit Nickel dotiertes Cobaltoxid. Derartige Füllstoffe 21 bilden bei ihrer Herstellung von selbst Sauerstofffehlstellen, die als Ladungsträger-Donatoren wirken und zur guten elektrischen Leitfähigkeit des Füllstoffes 21 beitragen. Eine durch eine Überspannung verursachte Teilentladung erhitzt den Füllstoff 21 lokal und bewirkt eine lokale Erzeugung von Ozon. Durch den Temperaturanstieg und das entstandene Ozon oxidieren Oberflächenrandschichten 25 der Füllstoffpartikel 23, die Sauerstofffehlstellen aufweisen. Dadurch wird die Anzahl der Sauerstofffehlstellen im Füllstoff 21 reduziert und die elektrische Leitfähigkeit des Verbundwerkstoffs 17 wird reduziert beziehungsweise der elektrische Widerstand des Verbundwerkstoffs 17 wird erhöht.

FIG 2 zeigt exemplarisch und schematisch eine Schnittdarstellung zweier sich berührender Füllstoffpartikel 23, die aus mit Antimon dotiertem Zinndioxid als Füllstoff 21 bestehen und durch eine Teilentladung oxidierte Oberflächenrandschichten 25 aufweisen. Ferner zeigt FIG 2 Verläufe einer oberen Valenzbandgrenze E_{V} eines Valenzbandes, einer unteren Leitungsbandgrenze E_{L} eines Leitungsbandes und einer Fermienergie E_{F} des Füllstoffs 21 entlang der Füllstoffpartikel 23. Durch die Oxidation der Füllstoffpartikel 23 steigen die obere Valenzbandgrenze E_{V} und die untere Leitungsbandgrenze E_{L} in einem Kontaktbereich 27 an, in dem die Oberflächenrandschichten 25 der Füllstoffpartikel 23 aneinander grenzen. In dem Kontaktbereich 27 bildet sich daher eine Potentialbarriere für Elektronen 29 in dem Leitungsband, die den elektrischen Widerstand des Verbundwerkstoffes 17 erhöht.

Statt eines der oben genannten Materialien kann der Füllstoff 21 aber auch ein anderes Material sein, beispielsweise ein n-leitendes Metalloxid ohne Dotierung, ein mit Fluor oder Indium dotiertes n-leitendes Metalloxid, beschichteter oder unbeschichteter Glimmer, Quarzmehl, Ruß, Graphit oder/und Metall, beispielsweise Kupfer. Im Falle, dass der Füllstoff 21 Kupfer ist, sind die Füllstoffpartikel 23 beispielsweise Kupferflakes. Füllstoffpartikel 23 aus Ruß, Graphit oder Metall bilden bei Teilentladungen keine Oberflächenrandschichten 25 der oben beschriebenen Art, sondern oxidieren bei Teilentladungen und verlieren dadurch ihre elektrische Leitfähigkeit, so dass sich der elektrische Widerstand des Verbundwerkstoffes 17 erhöht.

Alternativ können die Leiterbahnen 7, 8, 9 statt aus einem der oben genannten Verbundwerkstoffe 17 aus einem elektrisch leitfähigen Kunststoff, beispielsweise aus Polyanilin (PANI) oder aus Poly(3,4-ethylendioxythiophen)-Polystyrolsulfonat (PEDOT:PSS), gefertigt sein, dessen elektrische Leitfähigkeit durch Teilentladungen reduziert oder zerstört wird.

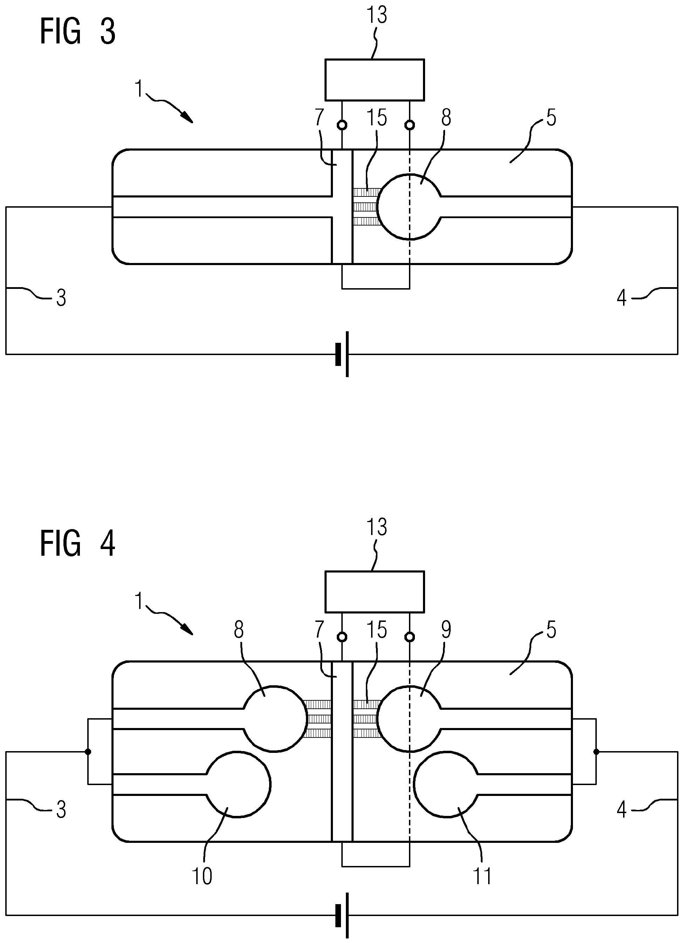

FIG 3 zeigt ein zweites Ausführungsbeispiel einer Nachweisvorrichtung 1 zum Nachweisen einer elektrischen Überspannung zwischen zwei elektrischen Leitern 3, 4. Dieses Ausführungsbeispiel unterscheidet sich von dem in FIG 1 gezeigten Ausführungsbeispiel dadurch, dass nur zwei Leiterbahnen 7, 8 auf dem Leiterbahnträger 5 aufgebracht sind. Dabei ist eine erste Leiterbahn 7 mit einem ersten elektrischen Leiter 3 elektrisch verbunden und die zweite Leiterbahn 8 ist mit dem zweiten elektrischen Leiter 4 elektrisch verbunden. Die erste Leiterbahn 7 ist außerdem mit der Messvorrichtung 13 zum Erfassen eines elektrischen Widerstandes der ersten Leiterbahn 7 elektrisch verbunden.

Die Leiterbahnen 7, 8 sind derart ausgebildet und angeordnet, dass eine vorgegebene Überspannung zwischen den elektrischen Leitern 3, 4 eine Teilentladung 15 zwischen der ersten Leiterbahn 7 und der zweiten Leiterbahn 8 bewirkt, die den elektrischen Widerstand der ersten Leiterbahn 7 auf einen zu der Überspannung korrespondierenden Widerstandswert ändert.

Um die Überspannung nachzuweisen, wird der elektrische Widerstand der ersten Leiterbahn 7 gemessen und es wird auf die Überspannung geschlossen, wenn der elektrische Widerstand der ersten Leiterbahn 7 den Widerstandswert annimmt.

FIG 4 zeigt ein drittes Ausführungsbeispiel einer Nachweisvorrichtung 1 zum Nachweisen einer elektrischen Überspannung zwischen zwei elektrischen Leitern 3, 4. Dieses Ausführungsbeispiel unterscheidet sich von dem in FIG 1 gezeigten Ausführungsbeispiel dadurch, dass fünf Leiterbahnen 7 bis 11 voneinander beabstandet auf dem Leiterbahnträger 5 aufgebracht sind.

Eine erste Leiterbahn 7 verläuft etwa in der Mitte des Leiterbahnträgers 5 zwischen zwei sich gegenüberliegenden Rändern des Leiterbahnträgers 5. Die beiden Enden der ersten Leiterbahn 7 sind mit einer Messvorrichtung 13 zum Erfassen eines elektrischen Widerstandes einer ersten Leiterbahn 7 verbunden.

Eine zweite Leiterbahn 8 und eine vierte Leiterbahn 10 sind mit einem ersten elektrischen Leiter 3 elektrisch verbunden und verlaufen senkrecht zu der ersten Leiterbahn 7 auf einer ersten Seite der ersten Leiterbahn 7. Der ersten Leiterbahn 7 zugewandte Enden der zweiten Leiterbahn 8 und der vierten Leiterbahn 10 sind jeweils kreisförmig ausgebildet und weisen voneinander verschiedene Abstände von der ersten Leiterbahn 7 auf.

Eine dritte Leiterbahn 9 und die fünfte Leiterbahn 11 sind mit dem zweiten elektrischen Leiter 4 elektrisch verbunden und verlaufen senkrecht zu der ersten Leiterbahn 7 auf einer der ersten Seite gegenüberliegenden zweiten Seite der ersten Leiterbahn 7. Der ersten Leiterbahn 7 zugewandte Enden der dritten Leiterbahn 9 und der fünften Leiterbahn 11 sind jeweils kreisförmig ausgebildet und weisen voneinander verschiedene Abstände von der ersten Leiterbahn 7 auf.

In dem in FIG 4 gezeigten Ausführungsbeispiel sind die Abstände der der ersten Leiterbahn 7 zugewandten Enden der zweiten Leiterbahn 8 und der dritten Leiterbahn 9 gleich und die Abstände der der ersten Leiterbahn 7 zugewandten Enden der vierten Leiterbahn 10 und der fünften Leiterbahn 11 sind ebenfalls gleich.

Die Leiterbahnen 7 bis 11 sind derart ausgebildet und angeordnet, dass eine vorgegebene erste Überspannung zwischen den elektrischen Leitern 3, 4 wie in FIG 4 gezeigt Teilentladungen 15 zwischen der ersten Leiterbahn 7 und der zweiten Leiterbahn 8 oder/und zwischen der ersten Leiterbahn 7 und der dritten Leiterbahn 9 bewirkt, und dass eine vorgegebene zweite Überspannung zwischen den elektrischen Leitern 3, 4, die größer als die erste Überspannung ist, zusätzlich Teilentladungen 15 zwischen der ersten Leiterbahn 7 und der vierten Leiterbahn 10 oder/und zwischen der ersten Leiterbahn 7 und der fünften Leiterbahn 11, wobei die von der ersten Überspannung bewirkten Teilentladungen den elektrischen Widerstand der ersten Leiterbahn 7 auf einen zu der ersten Überspannung korrespondierenden ersten Widerstandswert ändern und die von der zweiten Überspannung bewirkten Teilentladungen den elektrischen Widerstand der ersten Leiterbahn 7 auf einen zu der zweiten Überspannung korrespondierenden zweiten Widerstandswert, der größer als der erste Widerstandswert ist, ändern. Um die Überspannungen nachzuweisen, wird der elektrische Widerstand der ersten Leiterbahn 7 gemessen. Auf die erste Überspannung geschlossen, wenn der elektrische Widerstand der ersten Leiterbahn 7 den ersten Widerstandswert annimmt. Auf die zweite Überspannung wird geschlossen, wenn der elektrische Widerstand der ersten Leiterbahn 7 den zweiten Widerstandswert annimmt.

Mit der in FIG 4 gezeigten Nachweisvorrichtung 1 können daher zwei verschiedene Überspannungen nachgewiesen werden. Durch eine Erhöhung der Anzahl von Leiterbahnen 8 bis 11 mit verschiedenen Abständen zu der ersten Leiterbahn 7 kann das in FIG 4 gezeigte Ausführungsbeispiel dahingehend abgewandelt werden, dass eine noch größere Anzahl verschiedener Überspannungen nachgewiesen werden kann.

Die Leiterbahnen 7 bis 11 der in den Figuren 3 und 4 gezeigten Ausführungsbeispiele sind jeweils aus einem der Materialien gefertigt, die in der obigen Beschreibung des in FIG 1 gezeigten Ausführungsbeispiels genannt wurden. Die Leiterbahnen 7 bis 11 der in den Figuren 1, 3 und 4 gezeigten Ausführungsbeispiele weisen beispielsweise jeweils eine Dicke von etwa 100 µm und einen elektrischen Flächenwiderstand, der vor einer Teilentladung höchstens 100 kΩ beträgt, auf. Die Leiterbahnen 7 bis 11 werden beispielsweise durch ein Siebdruck- oder Dispenserdruckverfahren auf den Leiterbahnträger 5 aufgebracht.

Die anhand der Figuren beschriebenen Nachweisvorrichtungen 1 eignen sich insbesondere dazu, Überspannungen in einer elektrischen Maschine, insbesondere einer rotierenden elektrischen Maschine oder einem Transformator, nachzuweisen. Dabei ist wenigstens einer der elektrischen Leiter 3, 4 eine Spulenwicklung der elektrischen Maschine. Beispielsweise sind die beiden elektrischen Leiter 3, 4 Erregerwicklungen zweier verschiedener Phasen einer mehrphasigen rotierenden elektrischen Maschine, oder einer der beiden elektrischen Leiter 3, 4 ist eine Erregerwicklung einer rotierenden elektrischen Maschine und der andere elektrische Leiter 3, 4 ist ein geerdeter Leiter, oder einer der beiden elektrischen Leiter 3, 4 ist eine Primärwicklung oder Sekundärwicklung eines Transformators und der andere elektrische Leiter 3, 4 ist ein geerdeter Leiter. Dabei kann eine Spulenwicklung der elektrischen Maschine an einem Wicklungsende oder in dem Wicklungsinneren der Spulenwicklung mit wenigstens einer Leiterbahn 7 bis 11 elektrisch verbunden sein. Beispielsweise wird eine Leiterbahn 7 bis 11 mit einem elektrischen Leiter 3, 4 über eine Klemme eines Klemmenkastens oder Schaltschranks elektrisch verbunden. Eine Nachweisvorrichtung 1 der in FIG 4 gezeigten Art kann für elektrische Maschinen voneinander verschiedener Leistungsklassen verwendet werden, um Überspannungen nachzuweisen, die jeweils einer Leistungsklasse entsprechen.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Nachweisvorrichtung (1) zum Nachweisen einer elektrischen Überspannung zwischen zwei elektrischen Leitern (3,4), die Nachweisvorrichtung (1) umfassend
- einen aus einem elektrisch isolierenden Trägermaterial gefertigten Leiterbahnträger (5),
- wenigstens zwei voneinander beabstandet auf dem Leiterbahnträger (5) aufgebrachte Leiterbahnen (7 bis 11)
- und eine Messvorrichtung (13) zum Erfassen eines elektrischen Widerstandes einer ersten Leiterbahn (7),
- die Nachweisvorrichtung ist **dadurch gekennzeichnet, dass** jeder elektrische Leiter (3,4) mit wenigstens einer der Leiterbahnen (7 bis 11) elektrisch verbunden ist, keine Leiterbahn (7 bis 11) mit beiden elektrischen Leitern (3, 4) elektrisch verbunden ist, und die Leiterbahnen (7 bis 11) derart ausgebildet und angeordnet sind, dass eine vorgegebene Überspannung zwischen den elektrischen Leitern (3,4) eine den elektrischen Widerstand der ersten Leiterbahn (7) ändernde Teilentladung (15) zwischen der ersten Leiterbahn (7) und einer Leiterbahn (8 bis 11), die mit einem der beiden elektrischen Leiter (3,4) elektrisch verbunden ist, bewirkt.

2. Nachweisvorrichtung (1) nach Anspruch 1, **dadurch gekennzeichnet, dass** die erste Leiterbahn (7) zwischen zwei Leiterbahnen (8 bis 11), die jeweils mit einem der beiden elektrischen Leiter (3,4) elektrisch verbunden sind, und von diesen Leiterbahnen (8 bis 11) beabstandet angeordnet und nicht mit einem der beiden elektrischen Leiter (3,4) elektrisch verbunden ist.

3. Nachweisvorrichtung (1) nach Anspruch 1, **dadurch gekennzeichnet, dass** die erste Leiterbahn (7) mit einem der beiden elektrischen Leiter (3,4) elektrisch verbunden ist.

4. Nachweisvorrichtung (1) nach einem der vorhergehenden Ansprüche, **dadurch gekennzeichnet, dass** die Leiterbahnen (7 bis 11) aus einem Verbundwerkstoff (17) gefertigt sind, der eine elektrisch nichtleitende Kunststoffmatrix (19) und einen darin eingebetteten Füllstoff (21), durch den der Verbundwerkstoff (17) elektrisch leitfähig ist, umfasst.

5. Nachweisvorrichtung (1) nach Anspruch 4, **dadurch gekennzeichnet, dass** der Füllstoff (21) elektrisch leitfähige Füllstoffpartikel (23) aufweist, die Gitterplätze eines von der Kunststoffmatrix (19) gebildeten Gitters mit einer Wahrscheinlichkeit besetzen, die größer als eine Perkolationsschwelle ist, oberhalb derer der Verbundwerkstoff (17) elektrisch leitfähig ist, wobei die elektrische Leitfähigkeit von Füllstoffpartikeln (23) durch eine auf die Füllstoffpartikel (23) einwirkende Teilentladung (15) reduziert wird.

6. Nachweisvorrichtung (1) nach Anspruch 4 oder 5, **dadurch gekennzeichnet, dass** der Füllstoff (21) n-leitendes Metalloxid, beschichteten oder unbeschichteten Glimmer, Quarzmehl, Ruß, Graphit oder/und Metall enthält.

7. Nachweisvorrichtung (1) nach Anspruch 4 oder 5, **dadurch gekennzeichnet, dass** der Füllstoff (21) mit Antimon dotiertes Zinndioxid oder/und mit Fluor oder Indium dotiertes Zinnoxid enthält.

8. Nachweisvorrichtung (1) nach einem der Ansprüche 4 bis 7, **dadurch gekennzeichnet, dass** die Kunststoffmatrix (19) aus einem chemisch vernetzten Duroplast oder aus einem Thermoplast gefertigt ist.

9. Nachweisvorrichtung (1) nach einem der Ansprüche 1 bis 3, **dadurch gekennzeichnet, dass** die Leiterbahnen (7 bis 11) aus einem elektrisch leitfähigen Kunststoff gefertigt sind.

10. Nachweisvorrichtung (1) nach Anspruch 9, **dadurch gekennzeichnet, dass** die Leiterbahnen (7 bis 11) aus Polyanilin oder aus Poly(3,4-ethylendioxythiophen)-Polystyrolsulfonat gefertigt sind.

11. Nachweisvorrichtung (1) nach einem der vorhergehenden Ansprüche, **dadurch gekennzeichnet, dass** die Leiterbahnen (7 bis 11) jeweils eine Dicke von etwa 100 µm und einen elektrischen Flächenwiderstand, der vor einer Teilentladung (15) höchstens 100 kΩ beträgt, aufweisen.

12. Nachweisvorrichtung (1) nach einem der vorhergehenden Ansprüche, **dadurch gekennzeichnet, dass** der Leiterbahnträger (5) als ein Plättchen oder als eine Folie ausgebildet ist.

13. Nachweisvorrichtung (1) nach einem der vorhergehenden Ansprüche, **dadurch gekennzeichnet, dass** wenigstens einer der beiden elektrischen Leiter (3,4) mit mehreren Leiterbahnen (7 bis 11) elektrisch verbunden ist, wobei die Leiterbahnen (7 bis 11) derart ausgebildet und angeordnet sind, dass verschiedene vorgegebene Überspannungen zwischen den elektrischen Leitern (3,4) Teilentladungen (15) zwischen der ersten Leiterbahn (7) und verschieden vielen Leiterbahnen (8 bis 11), die jeweils mit einem der beiden elektrischen Leiter (3,4) elektrisch verbunden sind, bewirken.

14. Elektrische Maschine mit einer gemäß einem der vorhergehenden Ansprüche ausgebildeten Nachweisvorrichtung (1) zum Nachweisen einer elektrischen Überspannung zwischen zwei elektrischen Leitern (3,4), wobei einer der elektrischen Leiter (3,4) eine Spulenwicklung der elektrischen Maschine ist und der andere elektrische Leiter (3,4) eine andere Spulenwicklung der elektrischen Maschine oder ein geerdeter Leiter ist.

15. Elektrische Maschine nach Anspruch 14, **dadurch gekennzeichnet, dass** die elektrische Maschine eine rotierende elektrische Maschine oder ein Transformator ist.

16. Verfahren zum Nachweisen einer elektrischen Überspannung zwischen zwei elektrischen Leitern (3,4) mit einer gemäß einem der Ansprüche 1 bis 13 ausgebildeten Nachweisvorrichtung (1), wobei
- jeder elektrische Leiter (3,4) mit wenigstens einer Leiterbahn (7 bis 11) der Nachweisvorrichtung (1) elektrisch verbunden wird,
- der elektrische Widerstand der ersten Leiterbahn (7) der Nachweisvorrichtung (1) gemessen wird
- und auf eine elektrische Überspannung zwischen den elektrischen Leitern (3,4) geschlossen wird, wenn der elektrische Widerstand der ersten Leiterbahn (7) einen zu der Überspannung korrespondierenden Widerstandswert annimmt.

17. Verfahren nach Anspruch 16, wobei einer der elektrischen Leiter (3,4) eine Spulenwicklung einer elektrischen Maschine ist und der andere elektrische Leiter (3,4) eine andere Spulenwicklung der elektrischen Maschine oder ein geerdeter Leiter ist.

18. Verfahren nach Anspruch 17, **dadurch gekennzeichnet, dass** die elektrische Maschine eine rotierende elektrische Maschine oder ein Transformator ist.

## Claims

1. Verification device (1) for verifying an electrical overvoltage between two electrical conductors (3,4), the verification device (1) comprising
- a conductor-track carrier (5) made of an electrically insulating carrier material,
- at least two conductor tracks (7 to 11) applied spaced apart from one another on the conductor-track carrier (5)
- and a measuring device (13) for acquiring an electrical resistance of a first conductor track (7),
- the verification device is **characterised in that** each electrical conductor (3,4) is electrically connected to at least one of the conductor tracks (7 to 11), no conductor track (7 to 11) is electrically connected to both electrical conductors (3, 4) and the conductor tracks (7 to 11) are embodied and arranged such that a prespecified overvoltage between the electrical conductors (3,4) causes a partial discharge (15) that changes the electrical resistance of the first conductor track (7) between the first conductor track (7) and a conductor track (8 to 11) that is electrically connected to one of the two electrical conductors (3,4).

2. Verification device (1) according to claim 1, **characterised in that** the first conductor track (7) is arranged between two conductor tracks (8 to 11) that are each electrically connected to one of the two electrical conductors (3,4), and spaced apart from these conductor tracks (8 to 11) and is not electrically connected to one of the two electrical conductors (3,4).

3. Verification device (1) according to claim 1, **characterised in that** the first conductor track (7) is electrically connected to one of the two electrical conductors (3,4).

4. Verification device (1) according to one of the preceding claims, **characterised in that** the conductor tracks (7 to 11) are made of a composite material (17) comprising a non-electrically conductive plastic matrix (19) and a filler (21) embedded therein, thereby rendering the composite material (17) electrically conductive.

5. Verification device (1) according to claim 4, **characterised in that** the filler (21) comprises electrically conductive filler particles (23) that occupy lattice sites of a lattice formed by the plastic matrix (19) with a probability greater than a percolation threshold above which the composite material (17) is electrically conductive, wherein the electrical conductivity of the filler particles (23) is reduced by partial discharge (15) acting on the filler particles (23).

6. Verification device (1) according to claim 4 or 5, **characterised in that** the filler (21) contains n-conducting metal oxide, coated or uncoated mica, quartz powder, carbon black, graphite and/or metal.

7. Verification device (1) according to claim 4 or 5, **characterised in that** the filler (21) contains antinomy-doped tin dioxide and/or fluorine- or indium-doped tin dioxide.

8. Verification device (1) according to one of claims 4 to 7, **characterised in that** the plastic matrix (19) is made of a chemically crosslinked thermoset or a thermoplastic.

9. Verification device (1) according to one of claims 1 to 3, **characterised in that** the conductor tracks (7 to 11) are made of an electrically conductive plastic.

10. Verification device (1) according to claim 9, **characterised in that** the conductor tracks (7 to 11) are made of polyaniline or poly(3,4-ethylenedioxythiophene)-polystyrene sulfonate.

11. Verification device (1) according to one of the preceding claims, **characterised in that** the conductor tracks (7 to 11) each have a thickness of about 100 µm and an electrical sheet resistance of maximum 100 kΩ prior to a partial discharge (15).

12. Verification device (1) according to one of the preceding claims, **characterised in that** the conductor-track carrier (5) is embodied as a plate or a film.

13. Verification device (1) according to one of the preceding claims, **characterised in that** at least one of the two electrical conductors (3,4) is electrically connected to a plurality of conductor tracks (7 to 11), wherein the conductor tracks (7 to 11) are embodied and arranged such that different prespecified overvoltages between the electrical conductors (3,4) cause partial discharges (15) between the first conductor track (7) and different numbers of conductor tracks (8 to 11) that are each electrically connected to one of the two electrical conductors (3,4).

14. Electrical machine having a verification device (1) embodied according to one of the preceding claims for verifying an electrical overvoltage between two electrical conductors (3,4), wherein one of the electrical conductors (3,4) is a coil winding of the electrical machine and the other electrical conductor (3,4) is another coil winding of the electrical machine or a grounded conductor.

15. Electrical machine according to claim 14, **characterised in that** the electrical machine is a rotating electrical machine or a transformer.

16. Method for verifying an electrical overvoltage between two electrical conductors (3,4) having a verification device (1) according to one of claims 1 to 13, wherein
- each electrical conductor (3,4) is electrically connected to at least one conductor track (7 to 11) of the verification device (1),
- the electrical resistance of the first conductor track (7) of the verification device (1) is measured
- and it is concluded that there is an electrical overvoltage between the electrical conductors (3,4) if the electrical resistance of the first conductor track (7) assumes a resistance value corresponding to the overvoltage.

17. Method according to claim 16, wherein one of the electrical conductors (3,4) is a coil winding of an electrical machine and the other electrical conductor (3,4) is another coil winding of the electrical machine or a grounded conductor.

18. Method according to claim 17, **characterised in that** the electrical machine is a rotating electrical machine or a transformer.

## Revendications

1. Montage (1) de détection pour détecter une surtension électrique entre deux conducteurs (3, 4) électriques, le montage (1) de détection comprenant
- un support (5) de piste conductrice en un matériau de support isolant du point de vue électrique,
- au moins deux pistes (7 à 11) conductrices, déposées à distance l'une de l'autre sur le support (5) de piste conductrice
- et un dispositif (13) de mesure pour relever une résistance électrique d'une première piste (7) conductrice,
- le montage de détection est **caractérisé en ce que** chaque conducteur (3, 4) électrique est relié électriquement à au moins l'une des pistes (7 à 11) conductrices, aucune piste (7 à 11) conductrice n'est reliée électriquement aux deux conducteurs (3, 4) électriques et les pistes (7 à 11) conductrices sont constituées et disposées de manière à ce qu'une surtension donnée à l'avance entre les conducteurs (3, 4) électriques provoque une décharge (15) partielle, modifiant la résistance électrique de la première piste (7) conductrice, entre la première piste (7) conductrice et une piste (8 à 11) conductrice, qui est reliée électriquement à l'un des deux conducteurs (3, 4) électriques.

2. Montage (1) de détection suivant la revendication 1, **caractérisé en ce que** la première piste (7) conductrice est disposée entre deux pistes (8 à 11) conductrices, qui sont reliées électriquement chacune à l'un des deux conducteurs (3, 4) électriques, et à distance de ces pistes (8 à 11) conductrices et n'est pas reliée électriquement à l'un des deux conducteurs (3, 4) électriques.

3. Montage (1) de détection suivant la revendication 1, **caractérisé en ce que** la première piste (7) conductrice est reliée électriquement à l'un des deux conducteurs (3, 4) électriques.

4. Montage (1) de détection suivant l'une des revendications précédentes, **caractérisé en ce que** les pistes (7 à 11) conductrices sont en un matériau (17) composite, qui comprend une matrice (19) en matière plastique non conductrice de l'électricité et une charge (21), qui y est incorporée et par laquelle le matériau (17) composite est apte à conduire l'électricité.

5. Montage (1) de détection suivant la revendication 4, **caractérisé en ce que** la charge (21) comporte des particules (23) de charge conductrices de l'électricité, qui occupent des emplacements d'un réseau formé par la matrice (19) en matière plastique, avec une probabilité, qui est plus grande qu'un seuil de percolation, au-delà de laquelle le matériau (17) composite est conducteur de l'électricité, la conduction électrique de particules (23) de charge étant réduite par une décharge (15) partielle agissant sur les particules (23) de charge.

6. Montage (1) de détection suivant la revendication 4 ou 5, **caractérisé en ce que** la charge (21) contient un oxyde métallique à conduction n, du micas revêtu ou non revêtu, de la poudre de quartz, de la suie, du graphite ou/et un métal.

7. Montage (1) de détection suivant la revendication 4 ou 5, **caractérisé en ce que** la charge (21) contient du dioxyde d'étain dopé par de l'antimoine ou/et de l'oxyde d'étain dopé par du fluor ou par de l'indium.

8. Montage (1) de détection suivant l'une des revendications 4 à 7, **caractérisé en ce que** la matrice (19) de matière plastique est en un thermodurcissable réticulé chimiquement ou en un thermoplastique.

9. Montage (1) de détection suivant l'une des revendications 1 à 3, **caractérisé en ce que** les pistes (7 à 11) conductrices sont en une matière plastique conductrice de l'électricité.

10. Montage (1) de détection suivant la revendication 9, **caractérisé en ce que** les pistes (7 à 11) conductrices sont en polyaniline ou en poly(3,4-éthylènedioxythiophène)-polysulfonate de styrène.

11. Montage (1) de détection suivant l'une des revendications précédentes, **caractérisé en ce que** les pistes (7 à 11) conductrices ont chacune une épaisseur d'environ 100 µm et une résistance électrique de surface, qui est, avant une décharge (15) partielle, d'au plus 100 kΩ.

12. Montage (1) de détection suivant l'une des revendications précédentes, **caractérisé en ce que** le support (5) de piste conductrice est constitué sous la forme d'une plaquette ou d'une feuille.

13. Montage (1) de détection suivant l'une des revendications précédentes, **caractérisé en ce qu'**au moins l'un des deux conducteurs (3, 4) électriques est relié électriquement à plusieurs pistes (7 à 11) conductrices, les pistes (7 à 11) conductrices étant constituées et disposées de manière à ce que diverses surtensions données à l'avance provoquent des décharges (15) partielles entre la première piste (7) conductrice et diverses plusieurs pistes (8 à 11) conductrices, qui sont reliées électriquement chacune à l'un des deux conducteurs (3, 4) électriques.

14. Machine électrique comprenant un montage (1) de détection, constitué suivant l'une des revendications précédentes pour détecter une surtension électrique entre deux conducteurs (3, 4) électriques, l'un des deux conducteurs (3, 4) électriques étant un enroulement de bobine de la machine électrique et l'autre conducteur (3, 4) électrique étant un autre enroulement de bobine de la machine électrique ou un conducteur mis à la terre.

15. Machine électrique suivant la revendication 14, **caractérisée en ce que** la machine électrique est une machine électrique tournante ou un transformateur.

16. Procédé de détection d'une surtension électrique entre deux conducteurs (3, 4) électriques par un montage (1) de détection constitué suivant l'une des revendications 1 à 13, dans lequel
- on relie électriquement chaque conducteur (3, 4) électrique à au moins une piste (7 à 11) conductrice du montage (1) de détection,
- on mesure la résistance électrique de la première piste (7) conductrice du montage (1) de détection
- et on déduit une surtension électrique entre les conducteurs (3, 4) électriques, si la résistance électrique de la première piste (7) conductrice prend une valeur de résistance correspondant à la surtension.

17. Procédé suivant la revendication 16, dans lequel l'un des conducteurs (3, 4) électriques est un enroulement de bobine d'une machine électrique et l'autre conducteur (3, 4) électrique est un autre enroulement de bobine de la machine électrique ou un conducteur mis à la terre.

18. Procédé suivant la revendication 17, **caractérisé en ce que** la machine électrique est une machine électrique tournante ou un transformateur.
